(19) Europäisches Patentamt
European Patent Office
Office européen des brevets

(11) EP 0 695 082 B1

(12) EUROPEAN PATENT SPECIFICATION

(45) Date of publication and mention
of the grant of the patent:
29.09.1999 Bulletin 1999/39

(51) Int Cl.⁶: **H04N 3/15**, H03K 5/15

(21) Application number: 95305300.6

(22) Date of filing: 28.07.1995

(54) **Capacitive load driving circuit**

Treiberschaltung für eine kapazitive Last

Circuit d'attaque pour charge capacitive

(84) Designated Contracting States:
DE FR GB NL

(30) Priority: 28.07.1994 JP 17648594

(43) Date of publication of application:
31.01.1996 Bulletin 1996/05

(73) Proprietor: **KABUSHIKI KAISHA TOSHIBA**
Kawasaki-shi, Kanagawa-ken 210-8572 (JP)

(72) Inventors:
• **Sugiki, Tadashi, c/o Int. Prop. Div.**
**Tokyo (JP)**
• **Ando, Yukinori, c/o Int. Prop. Div.**
**Tokyo (JP)**

(74) Representative:
**O'Connell, David Christopher et al**
**Haseltine Lake & Co.,**
**Imperial House,**
**15-19 Kingsway**
**London WC2B 6UD (GB)**

(56) References cited:
**EP-A- 0 350 191**          **US-A- 5 285 370**

• **PATENT ABSTRACTS OF JAPAN vol. 014 no.**
**139 (E-0903) ,15 March 1990 & JP-A-02 002290**
**(TOSHIBA CORP) 8 January 1990,**
• **PATENT ABSTRACTS OF JAPAN vol. 014 no.**
**099 (E-0893) ,22 February 1990 & JP-A-01 303757**
**(HITACHI LTD) 7 December 1989,**
• **PATENT ABSTRACTS OF JAPAN vol. 005 no.**
**150 (P-081) ,22 September 1981 & JP-A-56**
**080893 (MATSUSHITA ELECTRIC IND CO LTD) 2**
**July 1981,**

## Description

The present invention relates to a capacitive load driving circuit such as a charge-coupled device type image pickup device or an electrostatic actuator which is used for a video camera, and more particularly, to a capacitive load driving circuit with a low power consumption.

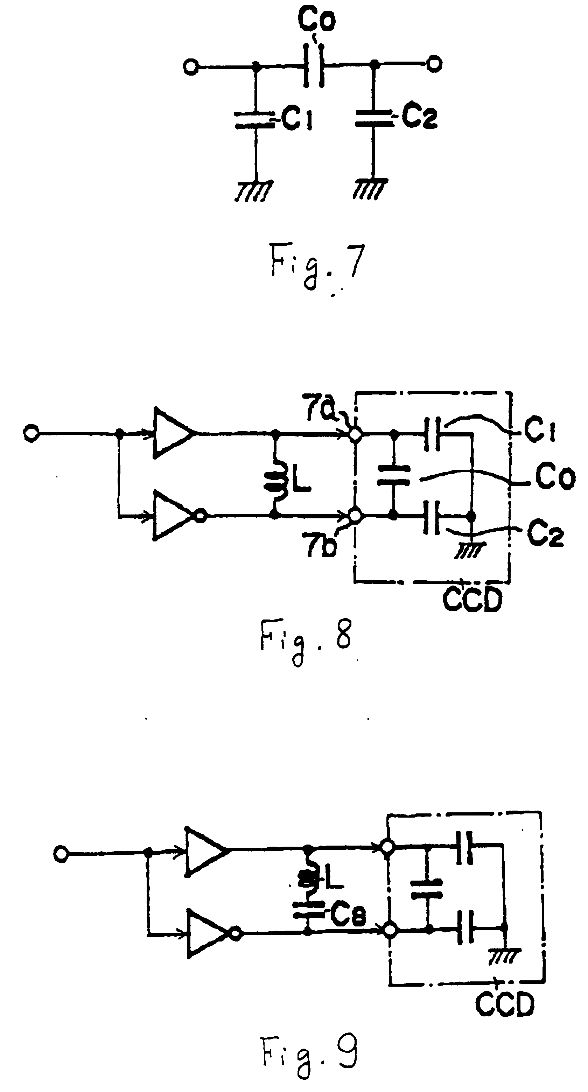

Capacitive load such as charge-coupled device (CCD) type image pickup devices and electrostatic actuators are used in many applications, due to it's features, such as small in size, light in weight, low in power consumption. However, driving systems for these capacitive loads are not necessarily a type of low power consumption. That is, the equivalent circuit of these elements may be of a low power consumption, without flowing a current in the quiescent time since the equivalent circuit is comprised of a capacitance $C_\phi$ coupled across driving terminals and capacitances C1, C2 of each terminals, as shown in FIGURE 7. However, these systems consume a relative amount of energy; given by [frequency] $\times$ [equivalent capacitance] $\times$ [driving voltage]$^2$ at the charging and discharging of the capacitance in the driving time. For instance, a CCD designed for HDTV with 1.300 thousands of pixels consumes a large amount of power as shown in the following equation, when the driving frequency is 48.6 MHz, the driving voltage is 6 V, and the equivalent capacitance is 300 pF.

$$48.6 \text{ MHz} \times 300 \text{ p} \times (6 \text{ V})^2 = 524 \text{ mW}$$

To solve the problems as described above, in a circuit disclosed in the Japanese Patent Disclosure: Tokkai-Sho 56-80893, an inductance element L is located across driving terminals 7a and 7b to construct a parallel resonance circuit with capacitances C0, C1, C2 at the driving terminals, a low power consumption is planed by making equal the resonance frequency with the driving duration.

The driving system is useful to transmit a signal continuously such as CCD delay line, but it had a problem that the CCD image pickup device having a quiescent time in the driving signal or the electrostatic actuator increase the power consumption since a relative amount of current flows through the inductance element during the quiescent time of the driving signal.

To solve the problems of the prior art example as described above, in the driving system disclosed in the Japanese Patent Disclosure Tokko-Hei 5-33875, a series circuit of a capacitor C8 and an inductance element L is coupled across the driving terminals, as shown in FIGURE 9. The capacitor C8 interrupts the current during the quiescent time for being low electric power.

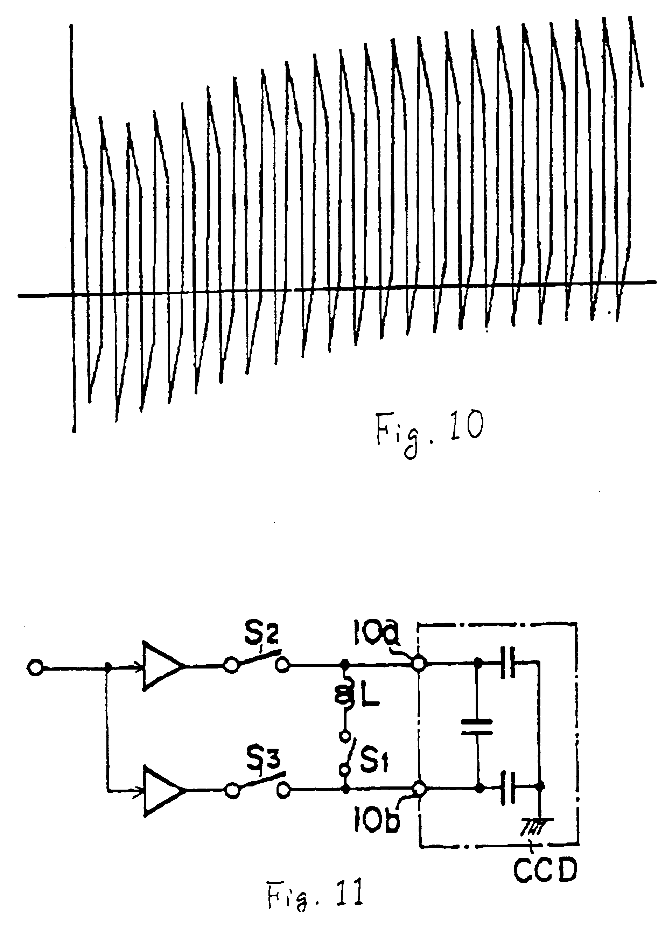

However, this driving system has also a problem that the driving waveform had a rise-time characteristic, as shown in FIGURE 10, since a resonance occurs around the voltage which is charged during the quiescent time, due to series circuit of the capacitor C8 and the inductance element L.

Further, in the driving system disclosed in the Japanese Patent Disclosure; Tokko-Hei 1-303757, a series circuit of a switch circuit S1 and an inductance element L is coupled between the driving terminals 10a and 10b, as shown in FIGURE 11. The switch S1 is opened to use an LC resonance at an inverting of the driving potential. The switch S1 is opened, while switches S2 and S3 connected in series with the driving voltage source are closed to protect the potential of the driving terminal when the driving potential was inverted.

However, this driving system has also drawbacks that the power consumption caused by an ON resistance of the switch S1 which is connected in series with the inductance element L, and the driving waveform is disturbed when the ON period of the switches are out of a half of the period of the resonance circuit composed of the inductance element L and the capacitors at the driving terminals.

As described above, the conventional capacitive load driving circuit have drawbacks that in the driving circuit wherein the inductance element is coupled across the driving terminals currents flow through the inductance in the quiescent time. While the driving circuit wherein the series circuit of the capacitor and the inductance element is coupled across the driving terminals has the problem in the rise-time characteristic in the driving waveform. Also the driving circuit wherein the series circuit of the switch and the inductance element is coupled across the driving terminals consumes a large amount of power due to the ON resistance of the switch.

It is, therefore, an object of the present invention to provide a capacitive load driving circuit with relatively low power consumption and desirable rise-time characteristic of the driving waveform.

According to the present invention, there is provided a circuit for driving a capacitive load by using a plurality of driving signals during different time periods including a quiescent time and a driving time, the capacitive load driving circuit comprising:

a separate driving voltage source connected to each driving terminal of the capacitive load; an inductance element connected across the driving terminals of the capacitive load; and a switch circuit provided between each driving voltage source and the corresponding driving terminal of the capacitive load;

characterized in that, at the quiescent time each switch circuit is closed and said separate voltage sources are adapted to force the driving terminals to be at the same potential, at the driving time the voltage sources provide voltages of equal amplitude and opposite phase to the driving terminals of the capacitive load, and at other times each switch circuit is opened.

According to the driving circuit as described above, a current does not flow in the quiescent time, even if the inductance is coupled across the driving terminals since a potential difference does not occur between the driving terminals. In the driving time, the switches are closed around the peaks of the driving waveform within the driving duration. The potential inversions at the driving terminals caused by the LC resonance make almost unnecessary the use of additional power supply. Further, since it has only one resonance frequency the rise-time characteristic of the driving waveform is desirable. Furthermore, since the inductance element is directly coupled across the driving terminals, the Q has a higher value and the energy loss will be small.

Additional objects and advantages of the present invention will be apparent to persons skilled in the art from a study of the following description and the accompanying drawings, which are hereby incorporated in and constitute a part of this specification.

For a better understandings of the present invention and many of the attendant advantages thereof, reference will now be made by way of example to the accompanying drawings, wherein:

FIGURE 1 is a circuit diagram for explaining one embodiment of the capacitive load driving circuit according to the present invention;
FIGURE 2 is a timing chart for explaining the operation of FIGURE 1;
FIGURE 3 is a circuit diagram for explaining another embodiment of the present invention;
FIGURE 4 is a circuit diagram for explaining still another embodiment of the present invention;
FIGURE 5 is a circuit diagram for explaining further embodiment of the present invention;
FIGURE 6 is a waveform diagram for explaining the effect of the still further embodiment of the present invention;
FIGURE 7 is an equivalent circuit showing a general capacitive load;
FIGURE 8 is a diagram showing a conventional driving circuit for driving a CCD with a low power consumption;
FIGURE 9 is a diagram showing another conventional driving circuit for driving a CCD with a low power consumption;
FIGURE 10 is a drawing for explaining the rise-time characteristic of the driving waveform in FIGURE 8; and
FIGURE 11 is a drawing showing still another conventional driving circuit for driving a CCD with a low power consumption.

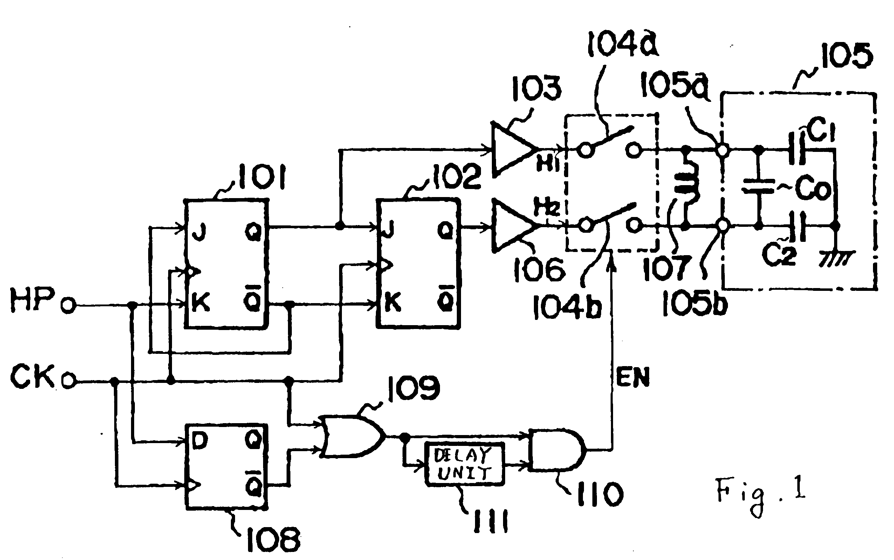

The present invention will be described in detail with reference to the FIGURES 1 through 6. Throughout the drawings, like or equivalent reference numerals or letters will be used to designate like or equivalent elements for simplicity of explanation.

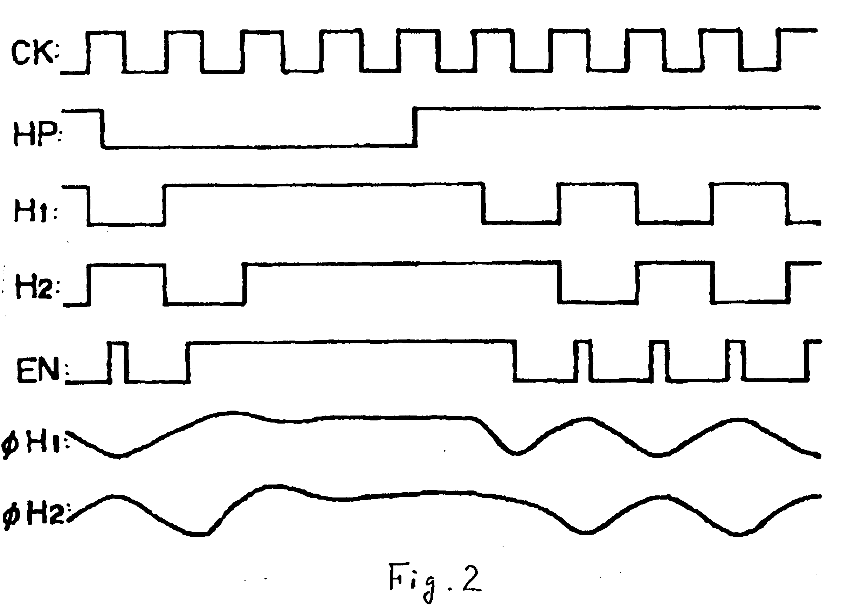

FIGURE 1 shows a circuit diagram for explaining one embodiment of the present invention, while FIGURE 2 shows a timing chart for explaining the operation.

In FIGURE 1, a terminal HP to which a halting pulse for halting a horizontal transfer CCD gives a potential to the K input of the JK flip-flop (JK-FF) 101. The J input of the JK-FF 101 is connected to the inverse Q output of the JK-FF 101. The Q output of the JK-FF 101 and it's inverse-Q output are connected to the J and K inputs of the JK-FF 102, respectively. The Q output of the JK-FF 101 is connected to a driving terminal 105a of a CCD 105 through a buffer amplifier 103 and a switch 104a, in the order. The Q output of the JK-FF 102 is connected to another driving terminal 105b of the CCD 105 through a buffer amplifier 106 and a switch 104b, in the order. An inductance element 107 is coupled across the driving terminals 105a and 105b.

The terminal HP is also connected to the D input of a D type flip-flop (D-FF) 108. A clock input terminal CK is connected to the clock inputs of the JK-FFs 101, 102, the D-FF 108 and to one input of an OR gate 109, the other input of the OR gate 109 is connected to the inverse-Q output of the D-FF 108. The output of the OR gate 109 is connected to one input of an AND gate 110 and also to the other input of the AND gate 110 through a delay unit 111. The output of the AND gate 110 controls ON or OFF the switches 104a and 104b.

Next, the operation of the above embodiment will be explained hereinafter. The terminal HP will remain in the low potential in the quiescent time. Accordingly the K input of the JK-FF 101 will be in the low potential. Since the J input of the JK-FF 101 is connected to the inverse-Q output of JK-FF 101, the J and K inputs of the JK-FF 101 become the low potential when the Q output of the JK-FF 101 is in the high potential. Then the Q output of the JK-FF 101 remains in the high potential even if the clock CK is input to the JK-FF 101. Since the J input of the JK-FF 101 is in the high potential, the K input is in the low potential, when the Q output of the JK-FF 101 is in the low potential Then the Q output will be in the high potential by next clock CK to be input. That is, the Q output of the JK-FF 101 will be in the high potential from the next clock of that to which the low potential is given to the HP terminal.

Since the J and K inputs of the JK-FF 102 are connected to the Q and the inverse-Q outputs of the JK-FF 101, respectively, the JK-FF 102 outputs are delayed by one clock period from the JK-FF 101 output. The outputs of the JK-FF 101 and 102 will be in the high potential, and the output signals H1 and H2 of the buffer amplifiers 103 and 104 will be in the high potential in the quiescent time. Further, in the quiescent time, the inverse-Q output of the D-FF 108 will be in the high potential. Then the output of the OF gate 109, the both inputs of the AND gate 110, and the control signal EN of the switches 104a and 104b which is output from the AND gate 110 will become in the high potential in the order. Accordingly, the terminals 105a and 105b of the CCD 105 continue to receive the high potentials.

Next, since the J input of the JK-FF 101 will be in the low potential as the HP terminal becomes high potential, the Q output of the JK-FF 101 will be in the low potential by the next clock CK to be input. Since the J and K inputs of the JK-FF 101 become the high potential at the next clock, the outputs of the JK-FF 101 will be inversed. That is, the JK-FF 101 inverses whenever the clock be input. So that the outputs of the JK-FF 101 will be divided by factor 2 for the frequency of the clock CK.

The JK-FF 102 delays the outputs of the JK-FF 101 by one clock period of the CK. Thus there is an inverse relationship between the Q output of the JK-FF 101 and the Q output of the JK-FF 102. Further, since the inverse-Q output of the D-FF 108 will be in the low potential the clock CK is output from the OR gate 109. The AND gate 110 is supplied two clocks having different timings through the direct line and the delay unit 111, and thus outputs narrow high potential pulses as the control signal EN. Using this control signal EN the switches 104a and 104b are closed only for a predetermined limited time to clamp the sinusoidal wave oscillation in a parallel resonance circuit which is comprised of the CCD 105 and the inductance element 107 for every peak and trough of the sinusoidal wave. So, driving waveforms φH1 and φH2 which appear on the driving terminals 105a and 105b will be desirable, as shown in FIGURE 2.

In this embodiment, the current does not flow in the quiescent time even if the inductance element 107 is coupled across the driving terminals 105a and 105b, since no potential difference is occurring across the driving terminals. In the driving time, the switches 104a and 104b are closed around the peak of the driving waveform at the driving period. The potential inversion of the driving terminals caused by the LC resonance makes almost unnecessary the power supply from the driving power source. Further, since it has only one resonance frequency the rise-time characteristic of the driving waveforms φH1 and φH2 are desirable. Furthermore, since the inductance element 107 is directly coupled across the driving terminals 105a and 105b the Q will take the high value and the energy loss will be smalll.

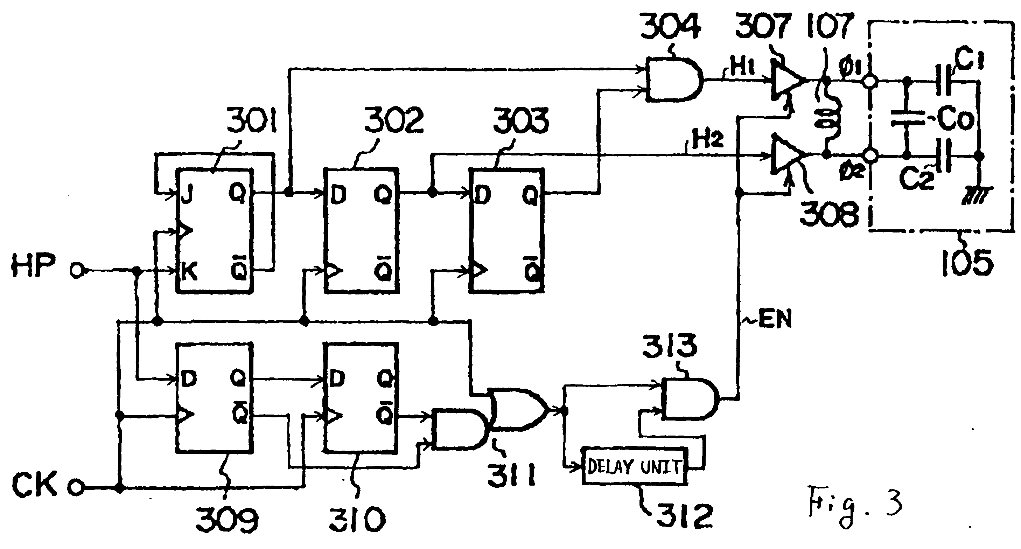

FIGURE 3 is a circuit diagram for explaining another embodiment of the present invention. In FIGURE 3, the JK-FF 301 performs an operation the same as the JK-FF 101 in FIGURE 1, the D-FFs 302 and 303 respectively delay its input signals for one clock period. Accordingly, a signal which have a high potential in the quiescent time and the frequency of factor 2 division for the clock for two and a signal which is delayed for two clock period are applied to the two inputs of the AND gate 304. The output pulse will become the output pulse H1 having pulses more than the output pulse H2 from the D-FF 302 by one pulse.

The HP signal which operates as the reference signal in the quiescent time is narrowed its width by one clock by the D-FFs 309, 310 and the AND•OR gate 311, and then executed an OR-logic operation with the clock CK. The OR gated signal is delayed in the delay line 312 to keep the high potential in the quiescent time and also to generate the small duty cycle control signal EN in the driving time by the AND gate 313. The signal is then applied to the control terminals of the three-state buffers 307 and 308. The three-state buffers 307 and 308 combine the function of the driving voltage source and the function of the switch, shown in FIGURE 1. Thus, it is possible to drive the CCD 105 with a small output resistance and also to drive with a low power consumption.

Now, it is assumed followings in the capacitive load driving circuit. That is, the capacitance difference CO across the driving terminals 105a and 105b of the CCD 105 is 60 pF, capacitances C1 and C2 across the driving terminals and ground potential are 40 pF. The capacitive load is the driven at the 48.6 MHz and 6 V amplitude. Then the driving circuit were able to drive the capacitive load with only the 31 mW power consumption, very small in compared with the 560 mW at the non resonance driving.

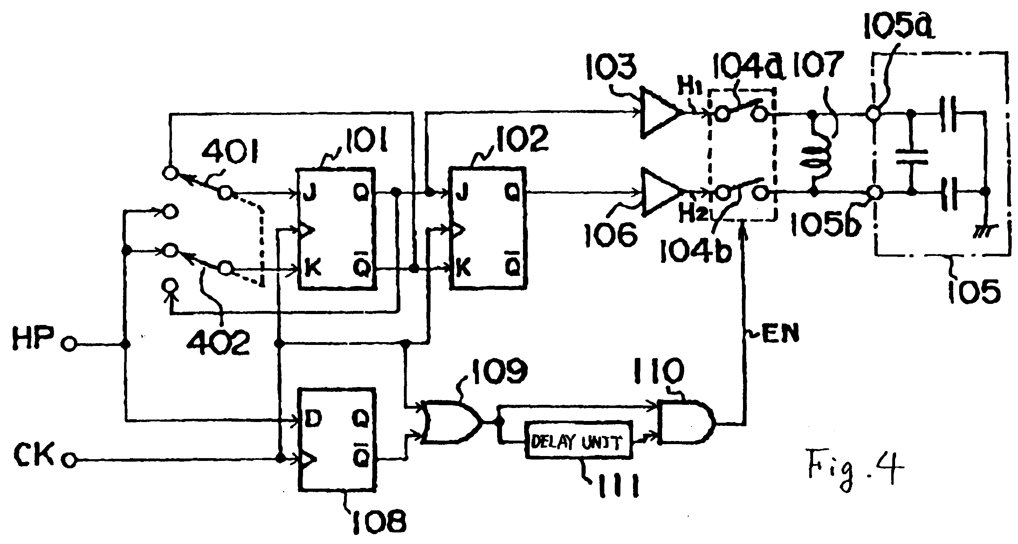

FIGURE 4 is a circuit diagram for explaining still another embodiment of the present invention which is able to optionally select the high potential or the low potential for the driving potential in the quiescent time. This embodiment is different from the FIGURE 1 in that further switches 401 and 402 are provided to the J and K inputs of the JK-FF 101.

In CCD image pickup devices, it is desirable to setup a higher potential for the CCD to rapidly sweep out undesired electric charges at the operation of electronic shutters into the drain of the horizontal transfer CCD next to the CCD. While it is desirable to setup a lower potential for the horizontal transfer CCD so as to make easy of receiving the signal potential from a vertical transfer CCD in a video signal outputting term.

That is, when the switches 401 and 402 are in the states as shown in FIGURE 4, the circuit of FIGURE 4 will operate, the same as the circuit of FIGURE 1. Whilst when the switches 401 and 402 take the other states and the HP terminal is in the quiescent time the Q outputs of the JK-FFs 101 and 102 will be in the low potential and the output signals H1 and H2 of the buffer amplifiers 103 and 106 will be in the low potential. Further, in the quiescent time, the inverse-Q output of the D-FF 108 will be in the low potential and the output of the OR gate 109, the both two inputs of the AND gate 110, and the control signal EN of switches 104a and 104b which is output from the AND gate 110 will be in the low potential in this order. Accordingly, the driving terminals 105a and 105b of the CCD 105 continue to receive the low potentials.

Accordingly, it is possible to optionally select the high potential and the low potential for the driving signals in the quiescent time by properly operating the switch 104a and 104b. In this embodiment, it is desirable to setup a higher potential for the CCD to rapidly sweep out undesired electric charges at the operation of electronic shutters into the drain of the horizontal transfer CCD next to the CCD. While it is desirable to setup a lower potential for the horizontal transfer CCD so as to make easy of receiving the signal potential from a vertical transfer CCD in a video signal outputting term.

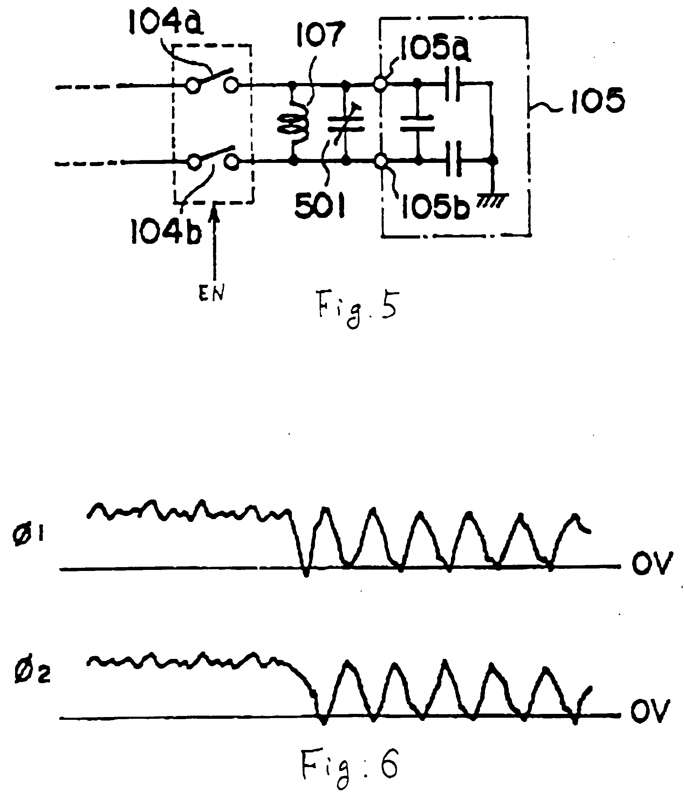

FIGURE 5 is a circuit diagram showing a fraction of the capacitive load driving circuit in which the switches 104a and 104b through the CCD 105 are depicted so as to explain a still further embodiment of the present invention. This embodiment has the feature of that a trimmer capacitor 501 is further coupled across the driving terminals 105a and 105b. i.e., across the inductance element 107. Even if the capacitances of the CCD 105 vary greatly, this embodiment ia able to greatly plan the saving of power consumption by matching the resonance frequency of the CCD 105 and the inductance element 107 with the driving frequency through the adjustment of the trimmer capacitor 501.

Further, it is able to suppress undershoots and overshoots in the driving waveforms, as shown in FIGURE 6, by adding a current limit circuit to the driving sources of the CCD 105 and the inductance element 107 so as to limit the slew rate of the rise-time of the driving waveform. The current limiting circuit is able to be performed by the buffer amplifiers in the above embodiments. It is thus essential only that any appropriate means capable of limiting current is provided.

As described above, the present invention can provide an extremely preferable capacitive load driving circuits which drive with a low power consumption and have a good rise-time characteristic of the driving waveform, and which accord the resonance frequency to the driving duration when the load capacity of the capacitive load vary greatly.

While there have been illustrated and described what are at present considered to be preferred embodiments of the present invention, it will be understood by those skilled in the art that various changes and modifications may be made, and equivalents may be substituted for elements thereof without departing from the true scope of the present invention. In addition, many modifications may be made to adapt a particular situation or material to the teaching of the present invention without departing from the central scope thereof. Therefor, it is intended that the present invention not be limited to the particular embodiment disclosed as the best mode contemplated for carrying out the present invention, but that the present invention includes all embodiments falling within the scope of the appended claims. For example, the capacitive load may be electrostatic motors or ultrasonic motors other than the CCDs.

The foregoing description and the drawings are regarded by the applicant as including a variety of individually inventive concepts, some of which may lie partially or wholly outside the scope of some or all of the following claims. The fact that the applicant has chosen at the time of filing of the present application to restrict the claimed scope of protection in accordance with the following claims is not to be taken as a disclaimer or alternative inventive concepts that are included in the contents of the application and could be defined by claims differing in scope from the following claims, which different claims may be adopted subsequently during prosecution, for example, for the purposes of a divisional application.

**Claims**

1. A circuit for driving a capacitive load (105) by using a plurality of driving signals during different time periods including a quiescent time, and a driving time the capacitive load driving circuit comprising:

   a separate driving voltage source (H1, H2, 103, 106) connected to each driving terminal of the capacitive load;
   an inductance element (107) connected across the driving terminals of the capacitive load; and
   a switch circuit (104a, 104b) provided between each driving voltage source and the corresponding driving terminal of the capacitive load;

   characterized in that, at the quiescent time each switch circuit is closed and said separate voltage sources are adapted to force the driving terminals to be at the same potential, at the driving time the voltage sources provide voltages of equal amplitude and opposite phase to the driving terminals of the capacitive load, and at other times each switch circuit is opened.

2. A capacitive load driving circuit as claimed in claim 1, characterized in that the driving voltage source and each switch circuit are comprised of three-state buffers.

3. A capacitive load driving circuit as claimed in claim 1, characterized in that a higher potential is applied to the driving terminals of the capacitive load during the quiescent time.

4. A capacitive load driving circuit as claimed in claim 1, characterized in that a lower potential is applied to the driving terminals of the capacitive load during the quiescent time.

5. A capacitive load driving circuit as claimed in claim 1, characterized in that a trimmer capacitor is coupled across the inductance element.

6. A capacitive load driving circuit as claimed in claim 1, characterized in that the capacitive load includes a charge-coupled device.

7. A capacitive load driving circuit as claimed in claim 1, characterized in that the driving voltage source has a maximum current limiting capability.

8. A capacitive load driving circuit as claimed in claim 1, characterized in that each switch circuit has a maximum current limiting capability.

## Patentansprüche

1. Schaltung zum Ansteuern einer kapazitiven Last (105) durch den Gebrauch einer Anzahl Ansteuersignale während unterschiedlicher Zeitperioden, die eine Ruhezeit und eine Ansteuerzeit enthalten, wobei die Schaltung zum Ansteuern einer kapazitiven Last umfaßt:

   eine getrennte Ansteuerspannungsquelle (H1, H2, 103, 106), die mit jedem Ansteueranschluß der kapazitiven Last verbunden ist; ein Induktivitätsbauteil (107), das zwischen die Ansteueranschlüsse der kapazitiven Last geschaltet ist; und eine Schalterschaltung (104a, 104b), die zwischen jeder Ansteuerspannungsquelle und dem entsprechenden Ansteueranschluß der kapazitiven Last bereitgestellt ist;

   dadurch gekennzeichnet, daß in der Ruhezeit jede Schalterschaltung geschlossen ist und die getrennten Spannungsquellen so eingerichtet sind, daß sie die Ansteueranschlüsse auf das gleiche Potential zwingen, und daß zur Ansteuerzeit die Spannungsquellen Spannungen mit gleicher Amplitude und entgegengesetzter Phase für die Ansteueranschlüsse der kapazitiven Last bereitstellen, und daß zu anderen Zeiten sämtliche Schalterschaltungen geöffnet sind.

2. Schaltung zum Ansteuern einer kapazitiven Last nach Anspruch 1, dadurch gekennzeichnet, daß die Ansteuerspannungsquelle und jede Schalterschaltung aus Dreizustands-Trennstufen besteht.

3. Schaltung zum Ansteuern einer kapazitiven Last nach Anspruch 1, dadurch gekennzeichnet, daß während der Ruhezeit ein höheres Potential an die Ansteueranschlüsse der kapazitiven Last angelegt wird.

4. Schaltung zum Ansteuern einer kapazitiven Last nach Anspruch 1, dadurch gekennzeichnet, daß während der Ruhezeit ein niedrigeres Potential an die Ansteueranschlüsse der kapazitiven Last angelegt wird.

5. Schaltung zum Ansteuern einer kapazitiven Last nach Anspruch 1, dadurch gekennzeichnet, daß ein einstellbarer Kondensator parallel zum Induktivitätsbauteil geschaltet ist.

6. Schaltung zum Ansteuern einer kapazitiven Last nach Anspruch 1, dadurch gekennzeichnet, daß die kapazitive Last ein Ladungsspeicherelement enthält.

7. Schaltung zum Ansteuern einer kapazitiven Last nach Anspruch 1, dadurch gekennzeichnet, daß die Ansteuerspannungsquelle den Strom auf einen Maximalwert begrenzen kann.

8. Schaltung zum Ansteuern einer kapazitiven Last nach Anspruch 1, dadurch gekennzeichnet, daß jede Schalterschaltung den Strom auf einen Maximalwert begrenzen kann.

## Revendications

1. Un circuit d'attaque pour charge capacitive (105) utilisant une pluralité de signaux d'attaque durant des périodes de temps différentes comprenant un temps de repos et un temps d'attaque, le circuit d'attaque pour charge capacitive comprenant :

   une source de tension d'attaque séparée (H1, H2, 103, 106) reliée à chaque borne d'attaque de la charge capacitive ;

   un élément d'inductance (107) relié entre les bornes d'attaque de la charge capacitive ; et

   un circuit de commutation (104a, 104b) prévu entre chaque source de tension d'attaque et la borne d'attaque correspondante de la charge capacitive ;

   caractérisé en ce que, au temps de repos, chaque circuit de commutation est fermé et en ce que lesdites sources de tension séparées sont adaptées pour amener à force les bornes d'attaque à être au même potentiel, en ce que, au temps d'attaque, les sources de tension fournissent aux bornes d'attaque de la charge capacitive des tensions d'amplitude égale et de phases opposées, et en ce que, à tous les autres temps, chaque circuit de commutation est ouvert.

2. Un circuit d'attaque pour charge capacitive tel que revendiqué à la revendication 1, caractérisé en ce que la source de tension d'attaque et chaque circuit de commutation sont composés de tampons à trois états.

3.  Un circuit d'attaque pour charge capacitive tel que revendiqué à la revendication 1, caractérisé en ce qu'un potentiel plus élevé est appliqué aux bornes d'attaque de la charge capacitive pendant le temps de repos.

4.  Un circuit d'attaque pour charge capacitive tel que revendiqué à la revendication 1, caractérisé en ce qu'un potentiel plus bas est appliqué aux bornes d'attaque de la charge capacitive pendant le temps de repos.

5.  Un circuit d'attaque pour charge capacitive tel que revendiqué à la revendication 1, caractérisé en ce qu'un condensateur ajustable est couplé aux bornes de l'élément d'inductance.

6.  Un circuit d'attaque pour charge capacitive tel que revendiqué à la revendication 1, caractérisé en ce que la charge capacitive comprend un dispositif à couplage de charge.

7.  Un circuit d'attaque pour charge capacitive tel que revendiqué à la revendication 1, caractérisé en ce que la source de tension d'attaque présente une capacité de limitation de courant maximum.

8.  Un circuit d'attaque pour charge capacitive tel que revendiqué à la revendication 1, caractérisé en ce que chaque circuit de commutation présente une capacité de limitation de courant maximum.

Fig.1

EP 0 695 082 B1

Fig.2

EP 0 695 082 B1

Fig. 3

Fig. 4

Fig. 5

Fig : 6

Fig. 7

Fig. 8

Fig. 9

Fig. 10

Fig. 11